# EUROPÄISCHE PATENTANMELDUNG

(11) **EP 1 972 951 A2**
(43) Veröffentlichungstag der Anmeldung: **24.09.2008**
(21) Anmeldenummer: 08004433.2
(22) Anmeldetag: 11.03.2008
(51) Int. Cl.: G01R 29/08, H05K 9/00

(54) **Abschirmmessung**

(30) Priorität: 19.03.2007 DE 102007013558
(71) Anmelder: Diehl BGT Defence GmbH & Co.KG, 88662 Überlingen (DE)
(72) Erfinder: Sonnemann, Frank, 90403 Nürnberg (DE); Stark, Robert, Dr., 91438 Bad Windsheim (DE); Von Entress-Fürstenbeck, Wolfgang, 90518 Altdorf/Rasch (DE)
(74) Vertreter: Diehl Patentabteilung

(57) **Zusammenfassung**

Verfahren zum Bestimmen der Abschirmungseigenschaften einer Abschirmung gegen elektromagnetische Strahlung, umfassend:
Aussenden der elektromagnetischen Strahlung zur Abschirmung, und Empfangen der durch die Abschirmung gedämpften elektromagnetischen Strahlung, wobei die ausgesandte elektromagnetische Strahlung zumindest einen Strahlungsimpuls umfasst, und das Empfangen eine zeitaufgelöste Messung der nach Aussenden des Strahlungsimpulses am Empfangsort eintreffenden Strahlung umfasst.

## Beschreibung

Die vorliegende Erfindung betrifft ein Verfahren und eine Vorrichtung zum Bestimmen der Abschirmungseigenschaften einer Abschirmung gegen elektromagnetische Strahlung gemäß dem Oberbegriff des Anspruchs 1 bzw. des Anspruchs 8.

Beim konventionellen Bestimmen der Abschirmungseigenschaften einer Abschirmung gegen elektromagnetische Strahlung wird die elektromagnetische Strahlung in Richtung der zu untersuchenden Abschirmung ausgesandt und die durch die Abschirmung gedämpfte elektromagnetische Strahlung hinter der Abschirmung empfangen. Aus dem Vergleich der Intensitäten der ausgesendeten elektromagnetischen Strahlung und der empfangenen elektromagnetischen Strahlung kann dann auf die Abschirmungs- bzw. Dämpfungseigenschaften der Abschirmung rückgeschlossen werden. Bei der zur Untersuchung der Abschirmungseigenschaften einer Abschirmung verwendeten elektromagnetischen Strahlung handelt es sich üblicherweise um sogenannte kontinuierliche Wellen (CW = Continuous Wave), d.h. um zeitlich nicht eng begrenzte Ausstrahlung elektromagnetischer Wellen. Häufig werden dabei reine Sinusschwingungen verwendet, um die Frequenzabhängigkeit der Abschirmungseigenschaften einer Abschirmung ermitteln zu können. Durch sequenzielles Durchschalten (sweep of frequencies) aller relevanten Frequenzen kann somit die Dämpfungscharakteristik einer Abschirmung in Abhängigkeit der sie beaufschlagenden Frequenzen ermittelt werden.

Die oben beschriebene Verfahrensweise eignet sich jedoch uneingeschränkt nur für die Untersuchung der Abschirmungseigenschaften von Abschirmungen in vollgeschirmten Bereichen, also für die Untersuchung von Abschirmungen, welche ein Volumen vollständig umschließen. Dann kann nämlich die Sendequelle der elektromagnetischen Strahlung in dem vollständig von der Abschirmung umschlossenen Volumen angeordnet werden und der Empfänger der durch die Abschirmung gedämpften elektromagnetischen Strahlung außerhalb des vollständig umschlossenen Volumens aufgestellt werden, ohne dass die Empfangsmessung von Anteilen der ausgesendeten elektromagnetischen Strahlung beeinflusst wird, welche den Empfänger auf indirektem Wege aufgrund von Streuung oder aufgrund von Beugungsvorgängen an (in diesem Fall nicht vorhandenen) Rändern der Abschirmung zum Empfangsort erreichen könnten.

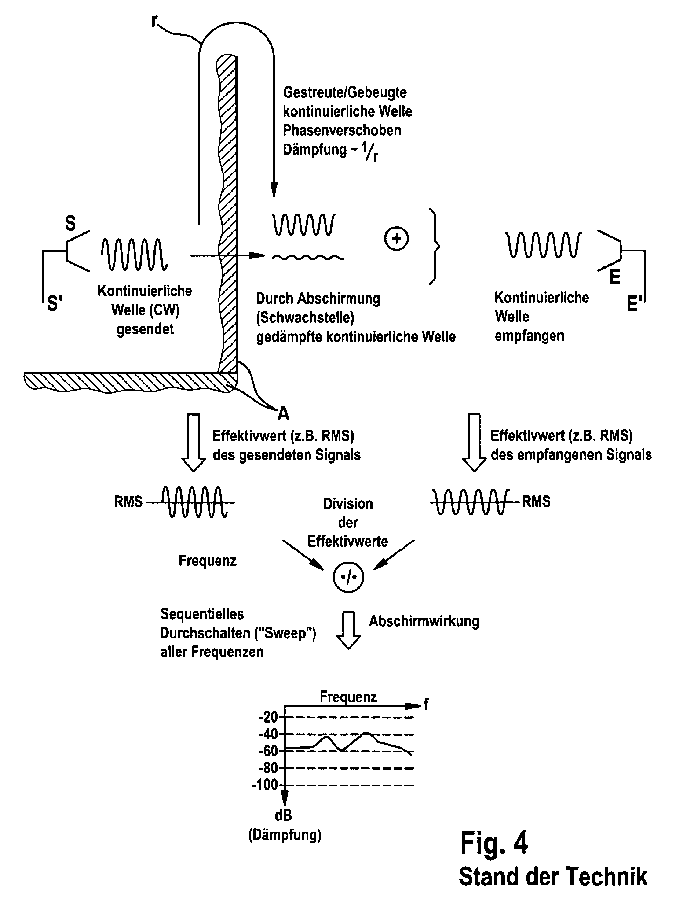

Das oben beschriebene Verfahren eignet sich somit in der Regel nicht für den Einsatz in teilgeschirmten Bereichen, d. h. zur Untersuchung von Abschirmungen, welche ein Volumen nicht vollständig umschließen also z. B. an den Seiten oder nach oben offene Abschirmungen wie z. B. eine allein stehende Wand. Das Problem bei der Anwendung der oben beschrieben konventionellen Methode in teilgeschirmten Bereichen ist schematisch in Figur 4 dargestellt. Dort besteht die Abschirmung A aus zwei senkrecht aufeinander stehenden Platten (wie es z. B. der Fall ist bei einer allein stehenden Wand, die auf dem Boden steht). Der Sender S wird am Aussendeort S' auf einer Seite der Wand aufgestellt und sendet sein CW-Signal auf die Wand zu. Das ausgesendete CW-Signal durchdringt die Abschirmung A in gedämpfter Form. Dabei ist die Dämpfung des CW-Signals umso geringer, je schwächer die Abschirmwirkung der Abschirmung A an der Stelle ist, auf die der Sender S das CW-Signal richtet. Das durch die Abschirmung A hindurch gedrungene gedämpfte CW-Signal wird auf der anderen Seite der Wand am Empfangsort E' vom Empfänger E empfangen und gemessen.

Aufgrund des Umstandes, dass es sich bei der Abschirmung A um keine Vollschirmung handelt, trifft jedoch im Empfänger E nicht nur die auf direktem Wege vom Aussendeort S' durch die Abschirmung A zum Empfangsort E' gelangende Strahlung ein, sondern auch Anteile des vom Sender S ausgesendeten CW-Signals, welche aufgrund von Streuung und/oder aufgrund von Beugungsvorgängen an Rändern der Abschirmung A auf indirektem Wege r um die Abschirmung A herum zum Empfänger E gelangen. Der direkt durch die Abschirmung gelangende Anteil sowie der gestreute/gebeugte Anteil des ausgesendeten CW-Signals addieren sich im Empfänger E zu einem Gesamtempfangssignal mit ebenfalls kontinuierlicher Wellenform mit gleicher Frequenz wie das ausgesandte CW-Signal. Aus den Effektivwerten (z. B. RMS = Root Mean Square) des ausgesandten CW-Signals und des empfangenen CW-Signals kann dann durch Verhältnisbildung der Werte auf die Abschirmwirkung der Abschirmung A rückgeschlossen werden.

Der Nachteil bei der oben beschriebenen konventionellen CW-Technik ist jedoch, dass das im Empfänger E empfangene Signal eine schlichte Superposition des direkt durch die Abschirmung gelangenden gedämpften Signals und des gestreuten/gebeugten Signals ist. Diese beiden Signalanteile können nicht voneinander getrennt werden, und deshalb ist eine ortsauflösende Bestimmung der Abschirmungswirkung an der Abschirmung A nicht möglich. Anders ausgedrückt, ist es nicht möglich festzustellen, ob ein niedriger Dämpfungswert bei Messung an einer bestimmten Stelle der Abschirmung A darauf zurückzuführen ist, dass die Abschirmung an dieser Stelle eine Schwachstelle aufweist oder ob der niedrige Dämpfungswert nur durch den gestreuten/gebeugten Anteil des ausgesendeten Signals hervorgerufen wird, der um die Abschirmung herum zum Empfänger E gelangt. Eine ortsauflösende Untersuchung der Abschirmwirkung eines teilgeschirmten Bereichs, um z. B. Leckagestellen oder Defekte in Teilbereichen von einzelnen Abschirmungsteilen aufzuspüren, ist mit dieser konventionellen Methode nicht möglich. Dieser Nachteil wiegt umso schwerer, als es auch beim Bau vollgeschirmter Bereiche (also Abschirmungen, welche ein Volumen vollständig umschließen) schon zu einem frühen Zeitpunkt des Baus, in dem erst Teile der Vollschirmung fertig gestellt sind, notwendig ist, schon in dieser frühen Bauphase die bereits existierenden Abschirmungsteile auf Leckagestellen oder Defekte hin zu untersuchen. Mit der oben beschriebenen konventionellen CW-Methode ist es deshalb erst nach vollständigem Abschluss der Bauphase des vollgeschirmten Bereichs möglich, festzustellen, ob die Abschirmung Leckagestellen aufweist oder nicht. Dies kann zu enormen Folgekosten (teilweiser Abriss und Wiederaufbau) zur Folge haben, die vermieden werden könnten, wenn zuverlässige Messwerte über die Abschirmwirkung bereits in der frühen Bauphase ermittelt werden könnten.

Es ist daher Aufgabe der vorliegenden Erfindung, eine zuverlässige Bestimmung der Abschirmungseigenschaften einer Abschirmung auch in teilgeschirmten Bereichen zu ermöglichen.

Diese Aufgabe wird für ein Verfahren nach dem Oberbegriff des Anspruchs 1 dadurch gelöst, dass die ausgesandte elektromagnetische Strahlung zumindest einen Strahlungsimpuls umfasst, und das Empfangen der durch die Abschirmung gedämpften elektromagnetischen Strahlung eine zeitaufgelöste Messung der nach Aussenden des Strahlungsimpulses am Empfangsort eintreffenden Strahlung umfasst.

Ferner wird diese Aufgabe für eine Vorrichtung nach dem Oberbegriff des Anspruchs 8 dadurch gelöst, dass der Sender eingerichtet ist, zumindest einen Strahlungsimpuls auszusenden, und der Empfänger eingerichtet ist, nach dem Aussenden des Strahlungsimpulses die am Empfangsort eintreffende Strahlung zeitaufgelöst zu empfangen.

Erfindungsgemäß wird also zur Bestimmung der Abschirmungseigenschaften einer Abschirmung elektromagnetische Strahlung in Form von Strahlungsimpulsen verwendet. Bei einem Strahlungsimpuls handelt sich um Strahlung deren Intensitätsentwicklung und Intensitätsabbau sich in einem engen zeitlichen Rahmen abspielen (z. B. innerhalb einer Nanosekunde). Innerhalb dieses engen zeitlichen Rahmens steigt die Intensität der Strahlung von 0 ausgehend auf einen Höchstwert an und sinkt kurze Zeit später wieder auf 0 ab. Dabei kommt es in der Regel nicht auf den genauen zeitlichen Verlauf der Intensitätsentwicklung an, sondern nur auf das zeitliche Integral über die Impulsdauer. Je kürzer die Impulsdauer ist, desto mehr Frequenzen sind in dem Impuls enthalten. Diese in dem Impuls enthaltenen Frequenzen können über eine schnelle Fourier-Transformation (FFT = Fast-Fourier-Transform) aus dem Zeitbereich (TD = Time-Domain) in den Frequenzbereich (FD = Frequency Domain) übertragen werden.

Die Verwendung von Strahlungsimpulsen in Verbindung mit einer zeitaufgelösten Messung der nach Aussenden des Strahlungsimpulses am Empfangsort eintreffenden Strahlung (_{"}zeitaufgelöste Messung" bedeutet, über die Dauer eines Zeitfensters zu jedem Zeitpunkt die momentan eintreffende Strahlungsintensität zu messen) hat den Effekt, dass der durch die Abschirmung gedämpfte Anteil des Strahlungsimpulses und der um die Abschirmung herum gestreute/gebeugte bzw. gebrochene Anteil des Strahlungsimpulses voneinander getrennt werden können. Der Grund für die Trennbarkeit dieser beiden Signalanteile liegt darin, dass die beiden Signalanteile mit unterschiedlicher Zeitverzögerung in Bezug auf den gemeinsamen Aussendezeitpunkt am Empfangsort empfangen werden. Grund für diese unterschiedliche Zeitverzögerung wiederum sind die unterschiedlich langen Laufwege der beiden Signalanteile. Während der direkt durch die Abschirmung hindurch tretende abgeschwächte Signalanteil einen relativ kurzen Laufweg hat (z. B. wenn der Sender nahe vor der Abschirmung und der Empfänger direkt hinter der Abschirmung angeordnet ist), ist der Laufweg des gestreuten/gebeugten Signalanteils um die Abschirmung herum relativ länger. Der direkt durch die Abschirmung hindurch tretende Signalanteil kommt also zeitlich vor dem gestreuten/gebeugten Signalanteil am Empfangsort an und kann somit mit einem Zeitbereichsverfahren (TD-Verfahren) vom Streuanteil separiert werden.

Vorzugsweise ist der Strahlungsimpuls ein kurzer UWB-Impuls (UWB = Ultra-Wide-Band). Ein solcher UWB-Impuls ist ein sehr kurzer Strahlungsimpuls und repräsentiert vorteilhafterweise ein besonders breites Frequenzspektrum (_{"}Ultra-Wide-Band", siehe Erläuterung oben). Dies hat den Vorteil, dass prinzipiell bereits mit einem einzigen Strahlungsimpuls über die Transformierung des Empfangssignals in den Frequenzbereich FD der komplette Frequenzbereich der Abschirmungsmessung abgedeckt ist.

Vorzugsweise wird für die Messung der am Empfangsort eintreffenden Strahlung ein Zeitfenster festgelegt. Dies hat den Vorteil, dass gezielt eine oder mehrere bestimmte Komponenten der am Empfänger eintreffenden Strahlung selektiert werden können. Andere als diese ausgewählten Komponenten können ausgefiltert werden.

Vorzugsweise beginnt dieses Zeitfenster vor Ablauf einer ersten Zeitspanne nach dem Aussendezeitpunkt des UWB-Impulses, die der Laufzeit des UWB-Impulses auf im Wesentlichen direktem Wege vom Aussendeort durch die Abschirmung zum Empfangsort entspricht. Dieser Anfangszeitpunkt kann beliebig lange vor dem Eintreffen der "direkten Komponente" (also desjenigen Anteils des UWB-Impulses, der den Empfänger vom Sender aus auf im wesentlichen direktem Wege durch die Abschirmung hindurch mehr oder weniger gedämpft erreicht) liegen, solange gewährleistet ist, dass nicht andere Störstrahlung (also entweder von außerhalb des Messsystems stammende Strahlung oder Strahlung von früher ausgesandten Messimpulsen), welche in den Empfänger einfällt, die Messung zu stark beeinflusst. Um den Einfluss von Störstrahlung möglichst gering zu halten, ist es vorteilhaft, den Anfangszeitpunkt möglichst nahe an den oben beschriebenen Ablauf der ersten Zeitspanne zu legen.

Vorzugsweise endet das Zeitfenster vor Ablauf einer zweiten Zeitspanne nach dem Aussendezeitpunkt des UWB-Impulses, die der Laufzeit von Anteilen des UWB-Impulses entspricht, die den Empfangsort auf indirektem Wege erreichen. Dadurch werden Strahlungsanteile, die zeitlich nach der "direkten Komponente" im Empfänger eintreffen, wirksam ausgefiltert. So können die zeitlich nachfolgenden indirekten Anteile des UWB-Impulses (gestreute/gebeugte Anteile), aber auch andere von außerhalb des Messsystems stammende Strahlung, welche die Güte der Abschirmungsmessung negativ beeinflussen, ausgefiltert werden. Übrig bleibt nach dem Ausfiltern über das Zeitfenster allein das interessierende Signal, nämlich die "direkte Komponente", welche die lokalen Abschirmeigenschaften der Abschirmung an der betreffenden Stelle charakterisiert.

Durch die Festlegung des Zeitfensters nach der oben beschriebenen Art und Weise wird also derjenige Signalanteil aus dem empfangenen Gesamtsignal herausgefiltert, welcher für die Bestimmung der ortsaufgelösten Abschirmwirkung von Interesse ist, nämlich gerade derjenige Anteil, der vom Sender durch die Abschirmung hindurch tritt und im Empfänger ankommt. Der andere Anteil des ausgesendeten Strahlungsimpulses, der um die Abschirmung herum gestreut bzw. gebeugt wird, kann damit ausgeblendet werden. Dies ist deshalb von Vorteil, da der gestreute/gebeugte Signalanteil nichts mit den Abschirmungseigenschaften der zu untersuchenden Abschirmung zu tun hat und lediglich ein verfälschendes Störsignal darstellt. Dies ist umso bedeutungsvoller, als der gestreute bzw. gebeugte Signalanteil eine um Größenordnungen höhere Intensität aufweist als der direkt durch die Abschirmung hindurch tretende gedämpfte Signalanteil.

Damit die Festlegung des Zeitfensters für die Messung am Empfangsort adäquat durchgeführt werden kann, ist es von Vorteil, dass der ausgestrahlte Strahlungsimpuls so kurz wie möglich ist. Dadurch ist auch das am Empfänger ankommende direkte Signal zeitlich möglichst eng begrenzt und eine leichtere bzw. bessere Trennbarkeit vom nachfolgenden Streusignal wird erreicht. Außerdem kann dadurch auch eine Messung der lokalen Abschirmeigenschaften bis nahe an den Rand einer Teilabschirmung (z. B. einer alleinstehenden Wand) realisiert werden, da bereits ein relativ kleiner Laufzeitunterschied von _{"}direkter Komponente" und indirekter Komponente (also Streustrahlung/gebeugte Strahlung um die Wand herum) ausreicht, um die beiden Komponenten im Empfänger zeitlich noch voneinander trennen zu können. Dabei ist es natürlich vorteilhaft, dass der Unterschied in der Zeitverzögerung, mit der der direkt durch die Abschirmung hindurch tretende Signalanteil und der gestreute Signalanteil am Empfangsort ankommen, groß genug ist, um das Ende des Zeitfensters so festlegen zu können, dass möglichst keine Anteile des gestreuten bzw. gebeugten Signals in das Zeitfenster fallen.

Vorzugsweise ist die erste Zeitspanne gleich 0 und der Beginn des Zeitfensters fällt mit dem Aussendezeitpunkt zusammen. Dies stellt eine schaltungstechnische Vereinfachung dar, da die Empfangsmessung gleichzeitig mit dem Sendebeginn gestartet werden kann. Vorausgesetzt es liegt keine signifikante externe Störstrahlung vor, hat diese Vergrößerung des Zeitfensters durch einen frühzeitigen Beginn auch keine Auswirkungen auf das Messergebnis.

Bei den oben erwähnten, den Empfangsort auf indirektem Wege erreichenden Anteilen des UWB-Impulses handelt es sich insbesondere um Anteile, welche aufgrund von Streuung und/oder aufgrund von Beugungsvorgängen an Rändern der Abschirmung zum Empfangsort gelangen. Es sind - wie oben bereits erwähnt - aber unter Umständen auch externe Störstrahlungen, die ihren Ursprung außerhalb des Messsystems haben, zu berücksichtigen. Diese externen Störungen sind in der Regel aber in ihrer Intensität um Größenordnungen geringer als die ausgesendete Messstrahlung.

Auf Grundlage der Intensität der in dem Zeitfenster am Empfangsort eintreffenden Strahlung und der Intensität der am Aussendeort ausgesandten Strahlung kann die Abschirmwirkung der Abschirmung bestimmt werden. Dies ist z. B. durch einfache Verhältnisbildung der Intensitäten möglich. Es sind aber auch andere, z. B. komplexere Bestimmungsmethoden möglich.

Vorzugsweise wird das im Zeitfenster empfangene Strahlungssignal einer schnellen Fourier-Transformation (FFT = Fast-Fourier-Transformation) unterzogen. Dadurch kann die Abschirmwirkung im Frequenzraum (FD) bestimmt werden, wobei der Gesamtfrequenzbereich, zu welchem entsprechende Dämpfungswerte der Abschirmung berechnet werden können, durch die Bandbreite des ausgestrahlten UWB-Impulses gegeben ist (siehe oben).

Vorzugsweise werden die oben beschriebenen Schritte jeweils an verschiedenen Stellen der Abschirmung wiederholt vorgenommen. Dadurch kann eine über die Fläche der Abschirmung ortsaufgelöste Messung der Abschirmwirkung der Abschirmung erreicht werden. Dies ist insbesondere vorteilhaft, wenn die Abschirmung auf Leckstellen oder lokale Schwachstellen hin untersucht werden soll, denn durch eine Vielzahl solcher Messungen können Unterschiede in der Stärke der Dämpfung von einem Ort der Abschirmung zum anderen festgestellt werden. Letztlich kann damit ein regelrechtes Abschirmprofil über die gesamte Fläche der Abschirmung erstellt werden (über das "bloße" Auffinden von Leckagestellen hinaus).

Zur Erläuterung der Merkmale und Vorteile der erfindungsgemäßen Vorrichtungen, welche in Ansprüchen 8 bis 12 beschrieben sind, wird auf die obige Darstellung verwiesen.

Die Erfindung schließt auch ein Computerprogramm ein, welches auf einem computerlesbaren Medium speicherbar ist und welches Strukturen enthält, die angepasst sind, die Verfahrensschritte eines der Verfahren der Ansprüche 1 bis 7 durchzuführen oder die funktionellen Merkmale einer der Vorrichtungen der Ansprüche 8 bis 12 zu implementieren. Dabei sind unter Strukturen insbesondere Datenstrukturen zu verstehen, welche Anweisung zur Durchführung der Verfahrensschritte eines der Verfahren der Ansprüche 1 bis 7 codieren. Die Erfindung umfasst ferner auch ein computerlesbares Medium, auf welchem das oben beschriebene Computerprogramm gespeichert ist.

Ferner umfasst die Erfindung die Verwendung eines der Verfahren nach Ansprüchen 1 bis 7 oder einer der Vorrichtungen nach Ansprüchen 8 bis 12 oder des Computerprogramms nach Anspruch 13 oder des computerlesbaren Mediums nach Anspruch 14 zum Auffinden von Schwachstellen oder Leckstellen in Abschirmungen, welche ein Volumen nicht vollständig umschließen (= teilgeschirmte Bereiche). Es wird jedoch betont, dass die Erfindung nicht auf die Anwendung bzw. Verwendung in teilgeschirmten Bereichen beschränkt ist, sondern beispielsweise auch in vollgeschirmten Bereichen Verwendung finden kann.

Weitere vorteilhafte Ausführungsformen und Verbesserungen der Erfindung ergeben sich aus nachstehender Beschreibung von bevorzugten Realisierungsbeispielen der Erfindung. Es wird darauf hingewiesen, dass die Erfindung auch weitere Ausführungsformen umfasst, die sich aus einer Kombination von Merkmalen ergeben, die getrennt in den Patentansprüchen und/oder in der Beschreibung und den Figuren aufgeführt sind.

Nachstehend wird die Erfindung anhand ihrer vorteilhaften Ausführungsformen unter Bezugnahme auf die Zeichnungen näher erläutert.

In den Zeichnungen bezeichnen die gleichen oder ähnlichen Bezugszeichen gleiche oder ähnliche Teile. In den Zeichnungen zeigen:
- Figur 1: eine schematische Darstellung des erfindungsgemäßen Verfahrens;
- Figur 2: den zeitlichen Verlauf der elektrischen Feldstärke am Empfangsort bei Anwendung des erfindungsgemäßen Verfahrens in einem teilgeschirmten Bereich;
- Figuren 3a, 3b und 3c: Momentdarstellungen der lokalen Verteilung des elektrischen Feldes hinter der Abschirmung nach 4 Nanosekunden (ns), 10 Nanosekunden bzw. 21 Nanosekunden (zum zeitlichen Bezug siehe auch Figur 2); und
- Figur 4: eine schematische Darstellung eines Verfahrens zur Bestimmung der Abschirmungseigenschaften einer Abschirmung unter Verwendung von kontinuierlichen Wellen (CW-Wellen).

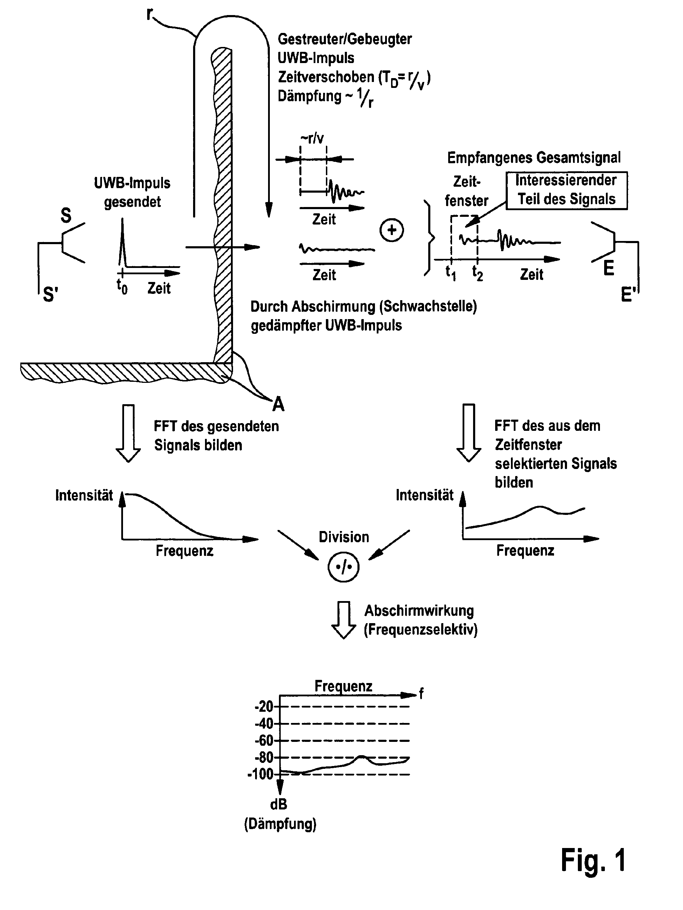

Unter Bezugnahme auf Figur 1 wird nun prinzipiell der erfindungsgemäße Gegenstand erläutert.

In einem teilgeschirmten Bereich, welcher von der Teilabschirmung A begrenzt wird (in diesem exemplarischen Fall zwei senkrecht aufeinander stehende Platten) wird am Aussendeort S' ein Sender S aufgestellt, der zum Zeitpunkt t₀ einen UWB-Impuls aussendet in Richtung einer der beiden Wandungen der Abschirmung A. Zu berücksichtigen sind in diesem Fall im Wesentlichen zwei Komponenten dieses ausgesendeten UWB-Impulses. Die erste Komponente breitet sich auf im Wesentlichen direktem Weg vom Sender S durch die Abschirmung A hindurch zum Empfänger E aus. Dabei kann es vorkommen, dass diese Strahlungskomponente die Abschirmung A an einer Schwachstelle durchtritt. In jedem Fall wird aber diese Komponente beim Durchtritt durch die Abschirmung A eine mehr oder weniger Starke Dämpfung erfahren. Die zweite Komponente des UWB-Impulses breitet sich in Folge von Streuung und/oder aufgrund von Beugungsvorgängen an Rändern der Abschirmung A auf indirektem Wege um die Abschirmung A herum auf dem längeren Weg r zum Empfänger E aus. Diese gestreute/gebeugte Komponente des UWB-Impulses erfährt aufgrund der endlichen Ausbreitungsgeschwindigkeit v (wobei v ungefähr gleich der Lichtgeschwindigkeit c im Vakuum gesetzt werden kann) eine Zeitverzögerung T_{D} = r/v beim Empfang im Empfänger E. Dabei erfährt die gestreute bzw. gebeugte Komponente die den Strahlungsgesetzen gehorchende entfernungsbedingte Dämpfung, welche proportional zu 1/r ist.

Das empfangene Gesamtsignal im Empfänger E setzt sich zusammen aus einer Superposition der Signale der ersten und der zweiten Komponente. Da diese beiden Komponenten unterschiedlich lange Laufstrecken durchlaufen, kommt die erste Komponente früher am Empfänger an als die zweite Komponente. Dieser Umstand kann nun ausgenutzt werden, indem ein Zeitfenster zwischen den beiden Zeitpunkten t₁ und t₂ im Empfänger gesetzt wird, in welchen die im Empfänger E empfangene Strahlung gemessen wird. Dieses Zeitfenster wird so gelegt, dass es möglichst nur die Strahlung der ersten UWB-Impuls-Komponente beinhaltet, also derjenigen Komponente, welche direkt durch die Abschirmung A hindurch getreten ist. Für die Messung der am Empfangsort E' eintreffenden Strahlung wird also ein Zeitfenster festgelegt, welches vor Ablauf der ersten Zeitspanne t₁ nach dem Aussendezeitpunkt t₀ des UWB-Impulses beginnt. Dabei entspricht die erste Zeitspanne t₁ der Laufzeit der ersten Komponente des UWB-Impulses auf im Wesentlichen direkten Wege vom Aussendeort S' durch die Abschirmung A zum Empfangsort E'. Das Zeitfenster endet vor Ablauf einer zweiten Zeitspanne t₂ nach dem Aussendezeitpunkt t₀ des UWB-Impulses. Diese zweite Zeitspanne t₂ entspricht der Laufzeit der zweiten Komponente des UWB-Impulses, welche den Empfangsort E' auf dem (kürzesten) Umweg r auf indirektem Wege erreicht. Auf diese Weise wird der interessierende Teil des empfangenen Gesamtsignals aus dem Gesamtsignal herausgefiltert, nämlich der Signalanteil, der direkt durch die Abschirmung A hindurch getreten ist, und der Streu- bzw. Störanteil der zweiten Komponente, welcher zeitlich nachfolgt, wird ausgefiltert. Dies ist insbesondere vor dem Hintergrund vorteilhaft, dass das Streusignal um Größenordnungen stärker als das abgeschwächte Messsignal der ersten Komponente ist.

Anschtießend können der ausgesendete UWB-Impuls und das aus dem Zeitfenster im Empfänger E selektierte Signal einer schnellen Fourier-Transformation (FFT) unterzogen werden, um die Abschirmwirkung der Abschirmung A im Frequenzraum bestimmen zu können. Durch Verhältnisbildung zwischen der aus dem Zeitfenster selektierten Komponente im Empfänger E und dem am Sender S ausgesendeten UWB-Impuls-Signal kann dann die Abschirmwirkung in Abhängigkeit der Frequenz an der betreffenden Stelle der Abschirmung A bestimmt werden. Der Vorteil dieser Methode besteht darin, dass man eine ortsaufgelöste Aussage über die Abschirmwirkung in einem bestimmten Bereich der Abschirmung A erhält, d.h. dass man nicht nur eine Aussage über die Gesamt-Abschirmwirkung der Abschirmung A erhält, sondern differenzierte Aussagen über lokale Bereiche der Abschirmung A. Wenn man mehrere dieser oben beschriebenen Messungen nacheinander vornimmt, kann man auf diese Weise ein Profil der Abschirmwirkung über die gesamte Fläche der Abschirmung A erhalten. Ferner ist es möglich, durch Vergleich der Werte der Einzelmessungen etwaige Schwachstellen in der Abschirmung A zu detektieren.

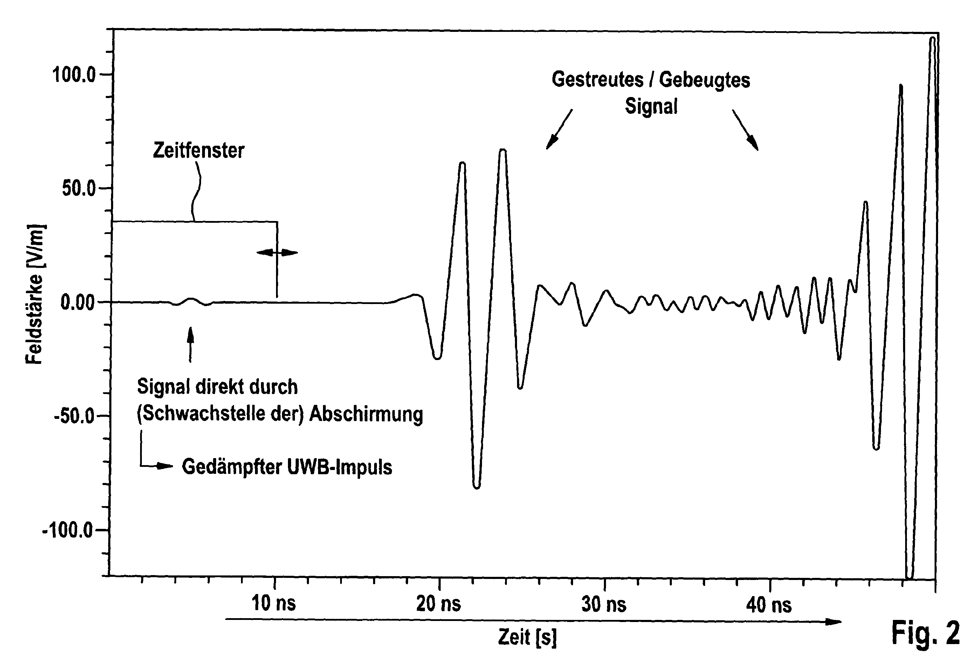

Figur 2 zeigt noch einmal in vergrößerter Darstellung den zeitlichen Verlauf des TD-Signals der elektrischen Feldstärke am Empfangsort E', wie es in Figur 1 in der rechten oberen Ecke schon angedeutet ist. Diesem TD-Signal liegt eine Messanordnung zugrunde, in der der Sender S 40 cm vor der Abschirmung steht und der Empfänger E am Empfangsort E' 50 cm hinter der Abschirmung A angeordnet ist.

Die Impulskomponente, welche direkt durch die Abschirmung A hindurch tritt, erreicht den Empfänger zuerst und ruft eine relativ kleine Signalamplitude im TD-Signal nach ca. 4 Nanosekunden hervor. Im dargestellten Fall beträgt die Signalamplitude dieser Impulskomponente lediglich ca. 1 V/m. Nach dem Einlaufen dieser ersten Impulskomponente geht die Signalamplitude des TD-Signals auf 0 zurück. Erst nach ungefähr 18 Nanosekunden nach dem Aussendezeitpunkt t₀ erreichen die ersten Ausläufer der gestreuten bzw. gebeugten Komponente des UWB-Impulses den Empfänger E. Deutlich ist zu sehen, dass die Amplitude der Feldstärke aufgrund der Streustrahlung um ca. zwei Größenordnungen größer ist (in der Spitze ca. 85 V/m nach ca. 21 Nanosekunden).

Da nur derjenige Signalteil für die Bestimmung der Abschirmungseigenschaften der Abschirmung A von Bedeutung ist, welcher zuerst im Empfänger E eintrifft (also derjenige nach ca. 4 Nanosekunden), wird dieser Signalanteil durch einen TD-Zeitfilter aus dem Gesamtempfangssignal extrahiert. Das Ende des Zeitfensters sollte dabei früher als die Zeitverzögerung gewählt werden, mit welcher die ersten Ausläufer der gestreuten bzw. gebeugten Anteile des UWB-Impulses am Empfänger E eintreffen. Auf der anderen Seite sollte das Ende des Zeitfensters natürlich nach dem Abklingen der ersten, direkt durch die Abschirmung A gedämpften Komponente liegen, um die Strahlung dieser gedämpften Komponente voll zu erfassen. Dieser Auswahlvorgang des Endes des Zeitfensters ist durch den Doppelpfeil am Zeitfenster in Figur 2 symbolisiert und ist nach den besonderen lokalen Einzelumständen (z. B. Form und Größe der Teilabschirmung) vorzunehmen und zu optimieren. Der Beginn des Zeitfensters kann zu einem beliebigen Zeitpunkt vor Ablauf der Zeitspanne t₁ erfolgen, nach welcher die direkt durch die Abschirmung A laufende Komponente am Empfänger E eintrifft, also in diesem Fall sollte der Beginn des Zeitfensters auf jeden Fall vor Ablauf von 3 bis 4 Nanosekunden nach dem Aussendezeitpunkt t₀ erfolgen. Wie schon weiter oben erwähnt wurde, kann der Beginn des Zeitfensters mit dem Aussendezeitpunkt t₀ zusammenfallen. So wurde auch der Beginn des Zeitfensters in Figur 2 gewählt.

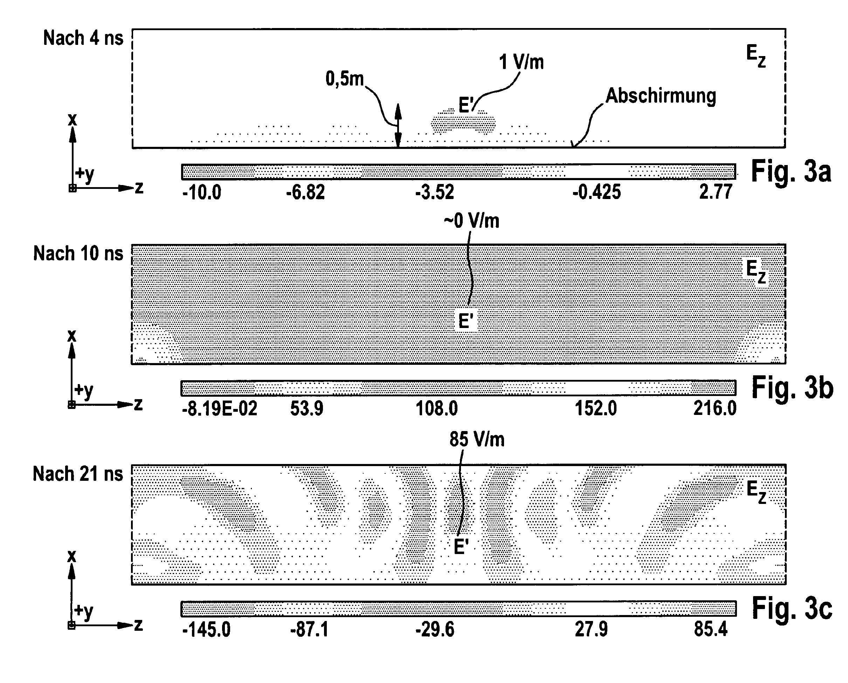

Figuren 3a, 3b und 3c führen den oben beschriebenen Sachverhalt anhand von Momentaufnahmen der Verteilung der elektrischen Feldstärke auf der Empfängerseite E' noch einmal plastisch vor Augen. Figur 3a zeigt die Situation nach 4 Nanosekunden, also zu dem Zeitpunkt, wo die direkt durch die Abschirmung A propagierende Komponente des UWB-Impulses am Empfangsort E' ankommt. Figur 3b zeigt die Situation nach 10 Nanosekunden, in welcher die Feldstärke am Empfangsort E' bereits wieder auf 0 abgesunken ist. Gleichzeitig sieht man zu dieser Zeit jedoch schon an den Rändern der Abschirmung A ein Ansteigen der Feldstärke, welches aus der um die Abschirmung A herumlaufenden gestreuten bzw. gebeugten Komponente des UWB-Impulses resultiert. Nach 21 Nanosekunden (siehe Figur 3c) ist die gestreute bzw. gebeugte Komponente des ausgesendeten Strahlungsimpulses vollständig um die Abschirmung A herumgelaufen und am Empfangsort E' eingetroffen. Die Feldstärke am Empfangsort E' steigt in der Spitze wieder auf ca. 85 Volt pro Meter an.

Da, wie schon weiter oben erwähnt, die elektrische Feldstärke der Stör- bzw. Streustrahlung um Größenordungen (hier ungefähr Faktor 100) größer ist als die elektrische Feldstärke, welche durch das direkt durch die Abschirmung A laufende Signal hervorgerufen wird, ist der Vorteil der erfindungsgemäßen Methode klar ersichtlich. Aufgrund dieser oben beschriebenen Methode kann eine Trennung der direkten und der indirekten Signalkomponente erreicht werden, wodurch präzise, teilbereichsgenaue Aussagen über die Abschirmwirkung von Abschirmungen in teilgeschirmten Bereichen möglich sind.

## Patentansprüche

1. Verfahren zum Bestimmen der Abschirmungseigenschaften einer Abschirmung (A) gegen elektromagnetische Strahlung, umfassend:
Aussenden der elektromagnetischen Strahlung zur Abschirmung (A), und Empfangen der durch die Abschirmung (A) gedämpften elektromagnetischen Strahlung,
**dadurch gekennzeichnet,**
**dass** die ausgesandte elektromagnetische Strahlung zumindest einen Strahlungsimpuls (P) umfasst, und
das Empfangen eine zeitaufgelöste Messung der nach Aussenden des Strahlungsimpulses (P) am Empfangsort (E') eintreffenden Strahlung umfasst.

2. Verfahren nach Anspruch 1,
wobei der Strahlungsimpuls (P) eine kurzer UWB-Impuls ist, und
für die Messung der am Empfangsort eintreffenden Strahlung ein Zeitfenster festgelegt wird, welches vor Ablauf einer ersten Zeitspanne (t₁) nach dem Aussendezeitpunkt (t₀) des UWB-Impulses (P) beginnt, die der Laufzeit des UWB-Impulses (P) auf im wesentlichen direkten Wege vom Aussendeort (S') durch die Abschirmung zum Empfangsort (E') entspricht, und welches vor Ablauf einer zweiten Zeitspanne (t₂) nach dem Aussendezeitpunkt (t₀) des UWB-Impulses (P) endet, die der Laufzeit von Anteilen des UWB-Impulses (P) entspricht, die den Empfangsort (E') auf indirektem Wege erreichen.

3. Verfahren nach Anspruch 2,
wobei die erste Zeitspanne (t₁) gleich Null ist und der Beginn des Zeitfensters mit dem Aussendezeitpunkt (t₀) zusammenfällt.

4. Verfahren nach Anspruch 2 oder 3,
wobei die den Empfangsort (E') auf indirektem Wege erreichenden Anteile des UWB-Impulses (P) solche Anteile umfassen, welche aufgrund von Streuung und/oder aufgrund von Beugungsvorgängen an Rändern der Abschirmung (A) zum Empfangsort (E') gelangen.

5. Verfahren nach einem der Ansprüche 2 bis 4,
wobei auf Grundlage der Intensität der in dem Zeitfenster am Empfangsort (E') eintreffenden Strahlung und der Intensität der am Aussendeort (S') ausgesandten Strahlung die Abschirmwirkung der Abschirmung (A) bestimmt wird.

6. Verfahren nach einem der Ansprüche 2 bis 5,
wobei das im Zeitfenster empfangene Strahlungssignal einer schnellen Fourier-Transformation (FFT) unterzogen wird und damit die Abschirmwirkung der Abschirmung (A) in Abhängigkeit der Frequenz der auf die Abschirmung (A) treffenden Strahlung bestimmt wird.

7. Verfahren nach einem der Ansprüche 1 bis 6,
wobei die Schritte des Aussendens und des Empfangens wiederholt an verschiedenen Stellen der Abschirmung (A) vorgenommen werden, um eine über die Fläche der Abschirmung (A) ortsaufgelöste Messung der Abschirmwirkung der Abschirmung (A) zu erreichen.

8. Vorrichtung zum Bestimmen der Abschirmungseigenschaften einer Abschirmung
(A) gegen elektromagnetische Strahlung, umfassend:
einen Sender (S) zum Aussenden der elektromagnetischen Strahlung zur Abschirmung (A), und
einen Empfänger (E) zum Empfangen der durch die Abschirmung (A) gedämpften elektromagnetischen Strahlung,
**dadurch gekennzeichnet,**
**dass** der Sender (S) eingerichtet ist, zumindest einen Strahlungsimpuls (P) auszusenden, und
der Empfänger (E) eingerichtet ist, nach dem Aussenden des Strahlungsimpulses (P) die am Empfangsort (E') eintreffende Strahlung zeitaufgelöst zu empfangen.

9. Vorrichtung nach Anspruch 8,
wobei der Strahlungsimpuls (P) eine kurzer UWB-Impuls ist, und
im Empfänger (E) für den zeitaufgelösten Empfang der am Empfangsort (E') eintreffenden Strahlung ein Zeitfenster festgelegt ist, welches vor Ablauf einer ersten Zeitspanne (t₁) nach dem Aussendezeitpunkt (t₀) des UWB-Impulses (P) beginnt, die der Laufzeit des UWB-Impulses (P) auf im wesentlichen direkten Wege vom Aussendeort (S') durch die Abschirmung (A) zum Empfangsort (E') entspricht, und welches vor Ablauf einer zweiten Zeitspanne (t₂) nach dem Aussendezeitpunkt (t₀) des UWB-Impulses (P) endet, die der Laufzeit von Anteilen des UWB-Impulses (P) entspricht, die den Empfangsort (E') auf indirektem Wege erreichen.

10. Vorrichtung nach Anspruch 9,
wobei die erste Zeitspanne (t₁) gleich Null ist und der Beginn des Zeitfensters mit dem Aussendezeitpunkt (t₀) zusammenfällt.

11. Vorrichtung nach einem der Ansprüche 8 bis 10,
ferner umfassend eine Recheneinheit, welche eingerichtet ist, auf Grundlage der Intensität der in dem Zeitfenster am Empfangsort (E') eintreffenden Strahlung und der Intensität der am Aussendeort (S') ausgesandten Strahlung die Abschirmwirkung der Abschirmung (A) zu bestimmen.

12. Vorrichtung nach Anspruch 11,
wobei die Recheneinheit ferner dazu eingerichtet ist, das im Zeitfenster empfangene Strahlungssignal einer schnellen Fourier-Transformation (FFT) zu unterziehen und damit die Abschirmwirkung der Abschirmung (A) in Abhängigkeit der Frequenz der auf die Abschirmung (A) treffenden Strahlung zu bestimmen.

13. Computerprogramm, welches auf einem computerlesbaren Medium speicherbar ist und welches Strukturen enthält, die angepasst sind, die Verfahrensschritte eines der Verfahren der Ansprüche 1 bis 7 durchzuführen oder die funktionellen Merkmale einer der Vorrichtungen der Ansprüche 8 bis 12 zu implementieren.

14. Computerlesbares Medium, auf welchem das Computerprogramm nach Anspruch 13 gespeichert ist.

15. Verwendung eines der Verfahren nach Ansprüchen 1 bis 7 oder einer der Vorrichtungen nach Ansprüchen 8 bis 12 oder des Computerprogramms nach Anspruch 13 oder des computerlesbaren Mediums nach Anspruch 14 zum Auffinden von Schwachstellen oder Leckstellen in Abschirmungen, welche ein Volumen nicht vollständig umschließen.
